# EUROPEAN PATENT SPECIFICATION

(11) **EP 0 471 292 B1**
(45) Date of publication and mention of the grant of the patent: **24.11.1999**
(21) Application number: 91113317.1
(22) Date of filing: 08.08.1991
(51) Int. Cl.: H01L 39/24

(54) **Substrate for superconducting devices**
Substrat für supraleitende Einrichtungen
Substrat pour dispositifs supraconducteurs

(30) Priority: 08.08.1990 JP 20978090; 08.08.1990 JP 20978190; 06.08.1991 JP 22090791
(43) Date of publication of application: 19.02.1992
(73) Proprietor: SUMITOMO ELECTRIC INDUSTRIES, LIMITED, Osaka 541 (JP)
(72) Inventor: Nakanishi, Hidenori, c/o Itami Works, Itami-shi, Hyogo (JP); Harada, Keizo, c/o Itami Works, Itami-shi, Hyogo (JP); Itozaki, Hideo, c/o Itami Works, Itami-shi, Hyogo (JP)
(74) Representative: Hansen, Bernd, Dr. Dipl.-Chem.

(56) References cited:
- EP-A- 0 341 502
- EP-A- 0 364 068
- EP-A- 0 435 765
- WO-A-89/10634
- APPLIED PHYSICS LETTERS vol. 56, no. 18, 30 April 1990, NEW YORK, US pages 1802
- - 1804; WIENER-AVNEAR E. ET AL: 'In situ laser deposition of Y1Ba2Cu3O7-x high Tc superconducting thin films with SrTiO3 underlayers'
- IEEE TRANSACTIONS ON MAGNETICS vol. 25, no. 2, March 1989, NEW YORK, US pages 961 - 964; CHIN D.K. ET AL.: 'Characterization of YBaCuO and ErBaCuO thin films deposited on silicon and gallium arsenide substrates'

## Description

### Background of the Invention

This invention relates to the use of a superconducting substrate in a microwave line, specifically to such a use of a substrate widely usable as a basic substrate in which various superconducting devices are made, and including a compound oxide superconducting film.

### (Related Background Art)

For a long time, superconductive phenomenon, which is thought to be caused by a phase transition of electrons, has been recognized as a phenomenon observed only at very low temperatures which can be realized only by the cooling by liquid helium. But in 1986 Bednorz, Muller et al. reported (La,Ba)₂CuO₄, which exhibits superconductivity at 30 K. In 1987, Chu et al. reported YBa₂Cu₃O_{y} having a superconductivity critical temperature Tc in the order of 90 K. In 1988, Maeda et al. reported the so-called Bi-system compound oxide superconducting material having a critical temperature higher than 100 K. These compound oxide superconductive materials can exhibit superconductive phenomenon even by cooling by inexpensive liquid nitrogen, and the potential of the practical applicability of superconduction technology has been noted.

Compound oxide superconducting materials having the above-described high critical temperatures were originally obtained as in sintered bodies by powder metallurgy. But the sintered bodies could not exhibit preferable characteristics, especially in critical current density, etc. Recently, processes for forming superconducting materials as thin films have been dominantly studied.

The compound oxide thin film formed by various kinds of conventionally known evaporation do not generally exhibit sufficient superconductivity as formed. In order to make them useful superconducting thin films, it is necessary to conduct post-anneal to the thus-formed compound oxide thin films. That is, it is generally known that compound oxide superconducting materials exhibit high oxygen non-stoichiometry, and also that the lower stoichiometry they have, the higher superconductivity they exhibit. In the conventional superconducting thin film, the post-annealing is performed for the purpose of supplementing oxygen for lack of oxygen caused by the oxygen non-stoichiometry, so that superconducting thin films exhibiting effective superconductivity are made.

But it is known that when a thin film formed on a substrate is annealed, the substrate material is diffused into the thin film under a high temperature for the annealing, and in the region near the substrate, the quality of the superconducting thin film is much degraded. The thus-treated thin film is usable in the region near the surface only for experimental purposes, but is not usable for practical purposes, such as making of various devices, etc.

Furthermore, even when a sufficiently thick superconducting thin film is successfully prepared, in fabricating various device with the obtained superconducting thin film, most of the devices cannot be completed by simply patterning the superconducting thin film. In a microwave device, for example, which is hopeful as an application field of the superconduction technique, the use of the superconducting thin film merely as wirings requires that conductor lines and ground conductor layers are arranged through a dielectric. It is disadvantageous in circuit design to fabricate such structure with only patterning on a single layer-superconducting thin film.

Furthermore, presently in fabricating an oxide superconducting thin film, very expensive materials, such as MgO single crystal substrates, SrTiO₃ single crystal substrate or others, are used as substrates, and therefore the cost of the superconducting substrates are very high. In this respect, the practicability of oxide superconducting thin film is low.

### Summary of the invention

An object of this invention is to provide the use of a superconducting substrate in a microwave line.

According to one aspect, the present invention provides the use of a multi-layer substrate in a microwave line for transmission of microwave signals, the multi-layer substrate comprising in order:
a base substrate formed from a silicon wafer or from sapphire;
a buffer layer;
a first superconducting oxide layer;
a dielectric layer having a thickness such that the characteristic impedance of the signal line is 50 Ω; and
a second superconducting oxide layer formed in a desired pattern.

In such a use, the multi-layer substrate may further include a second buffer layer between the dielectric and the second superconducting oxide layer.

It is preferred in such a use that the base substrate is a silicon wafer.

According to a second aspect, the present invention provides a microwave device having a multi-layer structure in a microwave line for transmission of microwave signals, the multi-layer structure comprising in order:
a base substrate formed from a silicon wafer or from sapphire;
a buffer layer;
a first superconducting oxide layer;
a dielectric layer having a thickness such that the characteristic impedance of the signal line is 50 Ω; and
a second superconducting oxide layer formed in a desired pattern.

In such a microwave device, a second buffer layer may be formed between the dielectric layer and the second superconducting oxide layer.

It is preferred in such a microwave device that the base substrate is a silicon wafer.

The present invention will become more fully understood from the detailed description which follows and the accompanying drawings which are given by way of illustration only, and thus are not to be considered as limiting the present invention.

### Brief Description of the Drawings

FIG. 1 is a sectional view of a basic structure of the substrate for superconducting devices of a first embodiment according to this invention; and
FIG. 2 is a sectional view of a basic structure of the substrate for superconducting devices of a second embodiment according to this invention.

### Description of the Preferred Embodiment

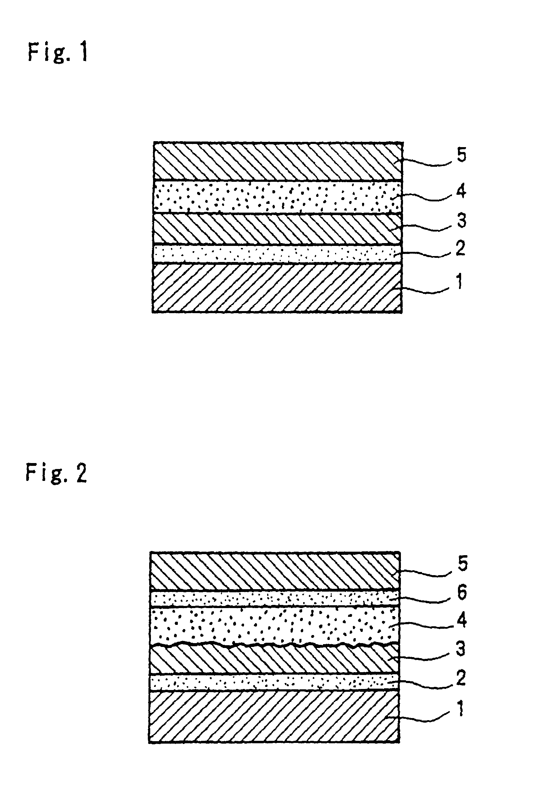

The multi-layer substrate for use in the first embodiment according to this invention has the so-called SIS type structure. FIG. 1 shows a sectional view of the SIS type structure. That is, the substrate of the first embodiment comprises a Si wafer 1 as the substrate, a buffer layer 2 formed on the Si wafer, a first superconducting oxide layer 3, a dielectric layer 4, and a second superconducting layer 5.

Thus, the substrate themselves for superconducting devices has the SIS type structure. This facilitates the fabrication of microwave devices. That is, it is generally possible that microwave devices are formed into filters, resonators, delay lines, etc. by setting the length, width and patterns of the microwave lines. By using the substrate according to the first embodiment, superconducting microwave devices can be fabricated simply by patterning.

It is generally basic that a microwave device comprises a conductor layer as a signal line and a grounding conductor which are formed through a dielectric layer. The conductor layer is variously patterned as a signal line to form a device. The quality homogeneity, etc. required of the grounding conductor layer is less severe than that of the signal conductor layer. Therefore the use of the first superconducting oxide layer 3 formed on the Si wafer 1 through a buffer layer as the ground plane layer can maintain the quality of the conductor layers as a whole high.

It often happen that the oxide layer 3 formed directly on the Si wafer 1 does not function as an effective superconducting layer. It is therefore necessary to form the buffer layer 2 on the Si wafer 1 before the formation of the first superconducting oxide layer 3. Variations of the buffer layer 2 can be proposed. To given an example, Y-system oxides can be exemplified as the buffer layer 2 for the case where a Bi-system oxide is used as the first superconducting oxide layer 3. That is, the Y-system oxides mean compound oxides comprising Y, Ba and Cu. It is known that these compound oxides themselves are superconducting oxides having high critical temperatures when they have specific compositions and crystal structures. But when the oxide layer 3 is formed directly on the Si wafer 1, the oxide layer 3 does not always exhibit effective superconducting characteristics. Here Y-system oxides may be used to form an effective buffer layer 2. The dielectric layer 4 formed between the pair of superconducting oxide layers 3 and 5 may preferably be formed from materials such as Y₂BaCuO₄, ZrO₂ or MgO.

The multi-layer substrate for use in this invention comprises a Si wafer as a base substrate. The use of a Si wafer is advantageous due to low material costs and because superconducting thin films having a large area can be obtained. That is, conventional superconducting oxide thin films have been formed on substrates of MgO single crystal, SrTiO₃, etc., but these substrate materials are very expensive. This has made the resultant superconducting oxide thin film as products expensive. In contrast to this, Si wafers of high quality are inexpensively marketed. This enables this invention to inexpensively provide the substrate for a microwave device according to this invention.

Next a first example of the first embodiment will be explained. As the first example of the sectional structure of FIG. 1, the inventors fabricated a substrate for superconducting devices comprising the buffer layer 2 and the dielectric laver 4 formed of a Y₂BaCuO₇₋ₓ thin film, and first and second superconducting oxide layers 3 and 5 formed of Bi₂Sr₂Ca₂Cu₃O_{y}. The respective layers were formed by sputtering. The film forming conditions are as shown in TABLE 1. The Si wafer as the substrate had a diameter of 50 mm. The thickness of the dielectric layer 4 was so set that the characteristic impedance of the signal line was 50 Ω.

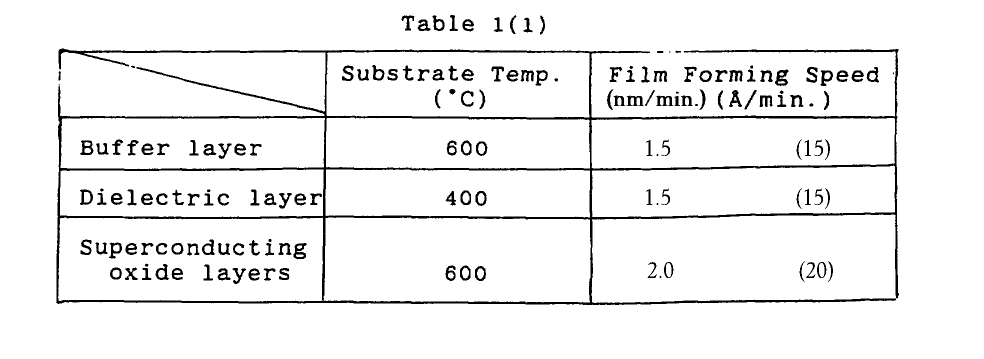

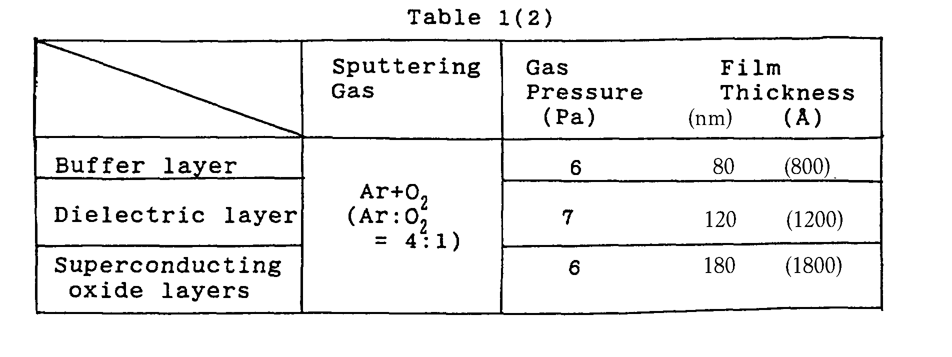

The thus-prepared substrates for superconducting devices were patterned into a 10 µm-width and 15 mm-length microwave line. The attenuation of a 10 GHz microwave signal was measured at 77K on this microwave line. The result was so low as 0.1 dB/cm.

Next the substrate for superconducting devices according to a second embodiment of this invention will be explained. FIG. 2 is a sectional view of the substrate. This substrate comprises a Si wafer 1 as the base substrate, a first superconducting oxide layer 3 formed on the Si wafer 1 through a buffer layer 2, and a dielectric layer 4 formed on the superconducting oxide layer 3, and a second superconducting oxide layer 5 formed on a dielectric layer 4 through a buffer layer 6. In the second embodiment as well, the substrate for superconducting devices per se constitutes an SIS structure, and consequently a microwave device can be easily fabricated. The conductor layer as a signal line is variously patterned to form devices, and high quality in large area are required. In this embodiment, the thin buffer layer 6 is sandwiched on the dielectric layer 4 to ensure the high quality of the uppermost layer 5. That is, the second buffer layer 5 formed on the dielectric layer 4 has a flatter surface than that of the dielectric layer 4. As a result, the quality of the second superconducting oxide layer 5 can be improved. Quality homogeneity required in the grounding conductor layer is lower than that of the signal conductor layer. The use of the first superconducting oxide layer 3 formed on the Si wafer 1 as the grounding conductor layer, can maintain a high quality for the conductor layers as a whole. The formation of the first superconducting oxide layer 3 made of a Y-system oxide thin film on the Si wafer 1 through the buffer layer 2 and the formation of the second superconducting oxide layer 5 made of Bi-system oxide thin film on the top can realize the reduction of the costs without degradation of the characteristics.

It often happen that the oxide layer 3 formed directly on the Si wafer does not function as an effective superconductor. Because of this, it is necessary to form the buffer layer 2 on the Si wafer 1 before the formation of the first superconducting oxide layer 3. The buffer layer 2 may be preferably formed from Y₁O₃ or ZrO₂.

An example of the second embodiment will be explained below. In this example, a substrate for superconducting devices was fabricated by forming the buffer layer 2 of ZrO₂ thin film, and the buffer layer 6 of YBa₂Cu₃O₇₋ₓ, the dielectric layer 4 of Y₂O₃, and the first and the second superconducting oxide layers 3, 5 of Bi₂Sr₂Ca₂Cu₃O_{y}. The respective layers were formed by sputtering. The film forming conditions were as shown in Table 2. The Si wafer as the substrate was 50 mm as a diameter there of. The thickness of the dielectric layer was so set that the characteristic impedance of the signal line is 50 Ω.

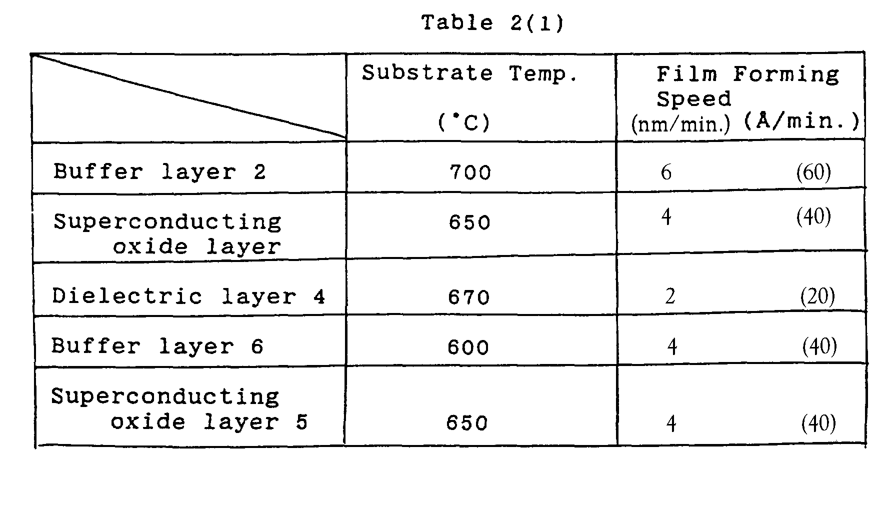

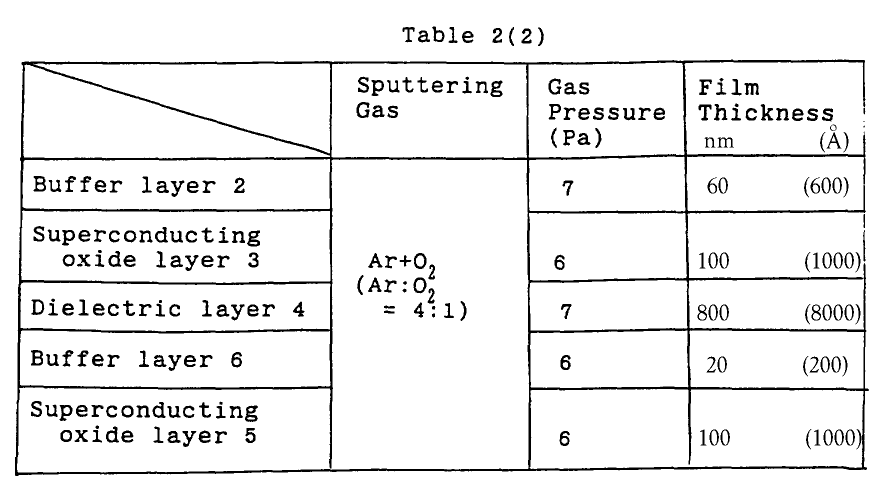

The thus-fabricated substrate for superconduction devices was patterned into 1µm-width and 10 mm-length microwave line was prepared. The attenuation of a 10 GHz microwave signal was measured at 77K. The attenuation was so low as 0.1 dB/cm. The microwave line test-prepared in the first example has a 10 µm-width and a 15 mm-length, and the attenuation was 0.1 dB/cm. It is seen that the provision of the second buffer layer much improves the characteristics.

The substrate for a microwave device according to this invention is characterized by the SIS type structure, which comprises the dielectric layer sandwiched by the superconducting oxide layers, the SIS type structure being formed on a substrate through the buffer layer. The materials of the substrate and the buffer layer are not limited to the above-described ones but may be their various combinations.

First, in forming the buffer layer on a (100) of a Si substrate, a ZrO₂ tetragonal crystal or a YSZ cubic crystal is used. These crystals grow, dislocated from the Si lattice by 45 °C, and little lattice incommensuration takes place. Since ZrO₂ and YSZ have thermal expansion coefficients between the thermal expansion coefficient of Si and those of superconductive oxides, cracks, etc, do not occur due to temperature differences between factrication and use. Furthermore, in growing a Y₂O₃ cubic crystal on a (100) of a Si substrate after the natural oxide film (SiO₂) has been completely removed, the buffer layer (Y₂O₃) has the (100) orientation, and the superconducting oxide layer can be formed on the (100) oriented buffer layer.

When a sapphire substrate is used in place of a Si substrate, a MgO cubic crystal is grown on an R plane of the sapphire, and the cubic MgO has the (100) orientation. MgO has a thermal expansion coefficient between the thermal expansion coefficients of sapphire and silicon, and those of superconductive materials. In many cases, MgO is used as a substrate having a low dielectric constant. It is possible that YSZ is grown on the R plane of sapphire as the buffer layer.

The multi-layer substrate for use in this invention is used in microwave lines by patterning the second superconducting oxide film, which is uppermost.

From the invention thus described, it will be obvious that the invention may be varied in many ways. Such variations are not to be regarded as a departure from the scope of the invention as claimed, and all such modifications as would be obvious to one skilled in the art are intended to be included within the scope of the following claims.

## Claims

1. The use of a multi-layer substrate in a microwave line for transmission of microwave signals, the multi-layer substrate comprising in order:
a base substrate formed from a silicon wafer or from sapphire;
a buffer layer;
a first superconducting oxide layer;
a dielectric layer having a thickness such that the characteristic impedance of the signal line is 50 Ω; and
a second superconducting oxide layer formed in a desired pattern.

2. The use of a multi-layer substrate in a microwave line for transmission of microwave signals, the multi-layer substrate comprising in order:
a base substrate formed from a silicon wafer or from sapphire;
a first buffer layer;
a first superconducting oxide layer;
a dielectric layer having a thickness such that the characteristic impedance of the signal line is 50 Ω;
a second buffer layer; and
a second superconducting oxide layer formed in a desired pattern.

3. The use according to Claim 1 or Claim 2, wherein the base substrate is a siliccn wafer.

4. The use according to Claim 3, wherein the buffer layer comprises Y₂BaCuO₄, ZrO₂, MgO, YSZ or Y₂O₃ formed on a (100) plane of the silicon substrate.

5. The use according to Claim 1 or Claim 2, wherein the base substrate is formed of sapphire.

6. The use according to Claim 5, wherein the buffer laver is a MgO or a YSZ layer formed on an R plane of the sapphire substrate.

7. The use according to Claim 1 or Claim 2, wherein the buffer layer between the base substrate and the first superconducting oxide layer is made of a material having a thermal expansion coefficient between that of the base substrate and that of the first superconducting oxide layer.

8. A microwave device having a multi-layer structure in a microwave line for transmission of microwave signals, the multi-layer structure comprising in order:
a base substrate formed from a silicon wafer or from sapphire;
a buffer layer;
a first superconducting oxide layer;
a dielectric layer having a thickness such that the characteristic impedance of the signal line is 50 Ω; and
a second superconducting oxide layer formed in a desired pattern.

9. A microwave device having a multi-layer structure in a microwave line for transmission of microwave signals, the multi-layer structure comprising in order:
a base substrate formed from a silicon wafer or from sapphire;
a first buffer layer;
a first superconducting oxide layer;
a dielectric layer having a thickness such that the characteristic impedance of the signal line is 50 Ω;
a second buffer layer; and
a second superconducting oxide layer formed in a desired pattern.

10. A microwave device according to Claim 8 or Claim 9, wherein the base substrate is a silicon wafer.

11. A microwave device according to Claim 10, wherein the buffer layer comprises Y₂BaCuO₄, ZrO₂, MgO, YSZ or Y₂O₃ formed on a (100) plane of the silicon substrate.

12. A microwave device according to Claim 8 or Claim 9, wherein the base substrate is formed of sapphire.

13. A microwave device according to Claim 12, wherein the buffer layer is a MgO or a YSZ layer formed on an R plane of the sapphire substrate.

14. A microwave device according to Claim 8 or Claim 9, wherein the buffer layer between the base substrate and the first superconducting oxide layer is made of a material having a thermal expansion coefficient between that of the base substrate and that of the first superconducting oxide layer.

## Patentansprüche

1. Verwendung eines Vielschichtsubstrats in einer Mikrowellenleitung für die Übertragung eines Mikrowellensignals, wobei das Vielschichtsubstrat die Reihenfolge umfaßt:
ein Grundsubstrat gebildet aus einem Silizium-Wafer oder aus Saphir,
eine Pufferschicht,
eine erste supraleitende Oxidschicht,
eine dielektrische Schicht, die eine Dicke aufweist, so daß die charakteristische Impedanz der Signalleitung 50 Ω ist, und
eine zweite supraleitende Oxidschicht gebildet in einem gewünschten Muster.

2. Verwendung eines Vielschichtsubstrats in einer Mikrowellenleitung zur Übertragung eines Mikrowellensignals, wobei das Vielschichtsubstrat die Reihenfolge umfaßt:
ein Grundsubstrat gebildet aus einem Silizium-Wafer oder aus Saphir,
eine erste Pufferschicht,
eine erste supraleitende Oxidschicht,
eine dielektrische Schicht, die eine Dicke aufweist, so daß die charakteristische Impedanz der Signalleitung 50 Ω ist,
eine zweite Pufferschicht und
eine zweite supraleitende Oxidschicht, die in einem gewünschten Muster gebildet wird.

3. Verwendung gemäß Anspruch 1 oder 2, worin das Grundsubstrat ein Silizium-Wafer ist.

4. Verwendung gemäß Anspruch 3, worin die Pufferschicht Y₂BaCuO₄, ZrO₂, MgO, YSZ oder Y₂O₃ umfaßt, gebildet auf einer (100) Fläche eines Siliziumsubstrats.

5. Verwendung gemäß Anspruch 1 oder 2, worin das Grundsubstrat aus Saphir gebildet wird.

6. Verwendung gemäß Anspruch 5, worin die Pufferschicht eine MgO oder eine YSZ Schicht, gebildet auf einer R-Fläche eines Saphirsubstrats, ist.

7. Verwendung gemäß Anspruch 1 oder 2, worin die Pufferschicht zwischen dem Grundsubstrat und der ersten supraleitenden Oxidschicht aus einem Material gemacht ist, das einen thermischen Ausdehnungskoeffizienten zwischen dem des Grundsubstrats und dem der ersten supraleitenden Oxidschicht hat.

8. Mikrowelleneinrichtung, die eine Vielschichtstruktur in einer Mikrowellenleitung zur Übertragung eines Mikrowellensignals hat, wobei die Vielschichtstruktur die Reihenfolge umfaßt:
ein Grundsubstrat gebildet aus einem Silizium-Wafer oder aus Saphir,
eine erste Pufferschicht,
eine erste supraleitende Oxidschicht,
eine dielektrische Schicht, die eine Dicke aufweist, so daß die charakteristische Impedanz der Signalleitung 50 Ω ist, und
eine zweite supraleitende Oxidschicht, die in einem gewünschten Muster gebildet wird.

9. Mikrowelleneinrichtung, die eine Vielschichtstruktur in einer Mikrowellenleitung zur Übertragung eines Mikrowellensignals hat, wobei die Vielschichtstruktur die Reihenfolge umfaßt:
ein Grundsubstrat gebildet aus einem Silizium-Wafer oder aus Saphir,
eine erste Pufferschicht,
eine erste supraleitende Oxidschicht,
eine dielektrische Schicht, die eine Dicke aufweist, so daß die charakteristische Impedanz der Signalleitung 50 Ω ist,
eine zweite Pufferschicht und
eine zweite supraleitende Oxidschicht, die in einem gewünschten Muster gebildet wird.

10. Mikrowelleneinrichtung gemäß Anspruch 8 oder 9, worin das Grundsubstrat ein Silizium-Wafer ist.

11. Mikrowelleneinrichtung gemäß Anspruch 10, worin die Pufferschicht Y₂BaCuO₄, ZrO₂, MgO, YSZ oder Y₂O₃ umfaßt, gebildet auf einer (100) Fläche eines Siliziumsubstrats.

12. Mikrowelleneinrichtung gemäß Anspruch 8 oder 9, worin das Grundsubstrat aus einem Saphir gebildet wird.

13. Mikrowelleneinrichtung gemäß Anspruch 12, worin die Pufferschicht eine MgO oder eine YSZ Schicht, gebildet auf einer R-Fläche des Saphirsubstrats, ist.

14. Mikrowelleneinrichtung gemäß Anspruch 8 oder 9, worin die Pufferschicht zwischen dem Grundsubstrat und der ersten supraleitenden Oxidschicht aus einem Material mit einem thermischen Ausdehnungskoeffizienten zwischen dem des Grundsubstrats und dem der ersten supraleitenden Oxidschicht besteht.

## Revendications

1. Application d'un substrat multicouche à une ligne à microondes de transmission de signaux de microondes, le substrat multicouche comprenant, dans l'ordre :
un substrat de base formé d'une tranche de silicium ou de saphir,
une couche tampon,
une première couche d'oxyde supraconducteur,
une couche diélectrique ayant une épaisseur telle que l'impédance caractéristique de la ligne de signaux est égale à 50 Ω, et
une seconde couche d'oxyde supraconducteur formée avec un motif voulu.

2. Application d'un substrat multicouche à une ligne à microondes destinée à la transmission de signaux de microondes, le substrat multicouche comprenant, dans l'ordre :
un substrat de base formé d'une tranche de silicium ou de saphir,
une première couche tampon,
une première couche d'oxyde supraconducteur,
une couche diélectrique ayant une épaisseur telle que l'impédance caractéristique de la ligne de signaux est de 50 Ω,
une seconde couche tampon, et
une seconde couche d'oxyde supraconducteur formée avec un motif voulu.

3. Application selon la revendication 1 ou 2, dans laquelle le substrat de base est une tranche de silicium.

4. Application selon la revendication 3, dans laquelle la couche tampon contient Y₂BaCuO₄, ZrO₂, MgO, YSZ ou Y₂O₃ formée sur un plan (100) du substrat de silicium.

5. Application selon la revendication 1 ou 2, dans laquelle le substrat de base est formé de saphir.

6. Application selon la revendication 5, dans lequel la couche tampon est une couche de MgO ou YSZ formée sur un plan R du substrat de saphir.

7. Application selon la revendication 1 ou 2, dans laquelle la couche tampon placée entre le substrat de base et la première couche d'oxyde supraconducteur est formée d'un matériau ayant un coefficient de dilatation thermique compris entre ceux du substrat de base et de la première couche d'oxyde supraconducteur.

8. Dispositif à microondes ayant une structure multicouche pour ligne à microondes destinée à la transmission de signaux de microondes, la structure multicouche comprenant dans l'ordre :
un substrat de base formé d'une tranche de silicium ou de saphir,
une couche tampon,
une première couche d'oxyde supraconducteur,
une couche diélectrique ayant une épaisseur telle que l'impédance caractéristique de la ligne de signaux est de 50 Ω, et
une seconde couche d'oxyde supraconducteur formée avec un motif voulu.

9. Dispositif à microondes ayant une structure multicouche dans une ligne à microondes pour la transmission de signaux de microondes, la structure multicouche comprenant, dans l'ordre :
un substrat de base formé d'une tranche de silicium ou de saphir,
une première couche tampon,
une première couche d'oxyde supraconducteur,
une couche diélectrique ayant une épaisseur telle que l'impédance caractéristique de la ligne de signaux est de 50 Ω,
une seconde couche tampon, et
une seconde couche d'oxyde supraconducteur formée avec un motif voulu.

10. Dispositif à microondes selon la revendication 8 ou 9, dans lequel le substrat de base est une tranche de silicium.

11. Dispositif à microondes selon la revendication 10, dans lequel la couche tampon comprend Y₂BaCuO₄, ZrO₂, MgO, YSZ ou Y₂O₃ formé sur un plan (100) du substrat de silicium.

12. Dispositif à microondes selon la revendication 8 ou 9, dans lequel le substrat de base est formé de saphir.

13. Dispositif à microondes selon la revendication 12, dans lequel la couche tampon est une couche de MgO ou de YSZ sur un plan R du substrat de saphir.

14. Dispositif à microondes selon la revendication 8 ou 9, dans lequel la couche tampon placée entre le substrat de base et la première couche d'oxyde supraconducteur est formée d'un matériau ayant un coefficient de dilatation thermique compris entre ceux du substrat de base et de la première couche d'oxyde supraconducteur.
